(19) Europäisches Patentamt
European Patent Office
Office européen des brevets

(11) **EP 2 824 465 A1**

(12) **EUROPEAN PATENT APPLICATION**
published in accordance with Art. 153(4) EPC

(43) Date of publication:
**14.01.2015 Bulletin 2015/03**

(51) Int Cl.:
**G01R 31/02** (2006.01)   **G01R 31/04** (2006.01)
**G01R 31/28** (2006.01)

(21) Application number: **12869650.7**

(22) Date of filing: **29.08.2012**

(86) International application number:
**PCT/JP2012/005415**

(87) International publication number:
**WO 2013/128503 (06.09.2013 Gazette 2013/36)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **01.03.2012   JP 2012045742**

(71) Applicant: **Kabushiki Kaisha Toshiba**
**Minato-ku**
**Tokyo 105-8001 (JP)**

(72) Inventors:
• **SETO, Motoshi**
**Minato-ku, Tokyo 105-8001 (JP)**
• **MURAKAMI, Hiroaki**
**Minato-ku, Tokyo 105-8001 (JP)**

(74) Representative: **Hoffmann Eitle**
**Patent- und Rechtsanwälte PartmbB**
**Arabellastraße 30**
**81925 München (DE)**

(54) **DEFECT DETECTION DEVICE**

(57)     A fault detection apparatus according to an embodiment is provided with a measurement unit, a memory unit, a control unit, and a display unit. The measurement unit measures a first time period taken until a reflection signal reflected on a fault of a test apparatus is received after a first signal is transmitted to the test apparatus. The memory unit includes a CAD data unit having CAD data of the test apparatus, and a model data unit to store model data indicating a relation between the first time period and a predicted conduction distance of the first signal according to the CAD data. The control unit calculates a range of a test object selected in the test apparatus based on the CAD data, calculates the predicted conduction distance from the first time period based on the model data, and specifies a position of a fault of the test apparatus which is separated by the predicted conduction distance from the measurement unit in the range of the test object. The display unit displays the position of the fault in the CAD data.

FIG.1

**EP 2 824 465 A1**

**Description**

CROSS REFERENCE TO RELATED APPLICATION

This application is based upon and claims the benefit of priority from the prior Japanese Patent Application No. 2012-045742, filed on March 1, 2012, the entire contents of which are incorporated herein by reference.

TECHNICAL FIELD

Embodiments described herein relate to a fault detection apparatus which detects a fault using time domain reflectometry (TDR), for example.

BACKGROUND ART

In a process of manufacturing an electronic apparatus which mounts electronic components on a mounting substrate, when the electronic components are mounted on the mounting substrate, connection portions on the mounting substrate and connection portions of the electronic components are connected by solder. The connection portions connected by solder are subjected to a test for checking whether a short circuit or an open circuit occurs.
As an example of a semiconductor apparatus, there is a BGA semiconductor apparatus. In the ball grid array, the solder balls serving as external terminals are disposed in a grid shape in the bottom face of a package, and connections to printed-circuit boards are made through the solder balls. In the printed-circuit board (the mounting substrate), it is difficult to visually confirm the state of the mounted solder balls. For the reason, a boundary scan or an X-ray inspection for example is performed.
Besides the boundary scan or the X-ray inspection, there is proposed a soldering inspection apparatus using a time domain reflectometry (TDR) apparatus for example.

PRIOR ART DOCUMENTS

   Patent Literature 1: Japanese Patent Application Publication No. 2003-124851
   Patent Literature 2: Japanese Patent Application Publication No. 09-61486

SUMMARY OF INVENTION

TECHNICAL PROBLEM

There is provided a fault detection apparatus which can detect a fault of a test apparatus with a high accuracy.

SOLUTION TO PROBLEM

A fault detection apparatus according to an embodiment is provided with a measurement unit, a memory unit, a control unit, and a display unit. The measurement unit measures a first time period taken until a reflection signal reflected on a fault of a test apparatus is received after a first signal is transmitted to the test apparatus. The memory unit is provided with a CAD data unit which has CAD data of the test apparatus and a model data unit which stores model data indicating a relation between the first time period and a predicted conduction distance of the first signal according to the CAD data. The control unit calculates a range of a test object which is selected in the test apparatus based on the CAD data, calculates the predicted conduction distance from the first time period based on the model data, and specifies a position of the fault of the test apparatus which is separated from the measurement unit by the predicted conduction distance in the range of the test object. The display unit displays the position of the fault in the CAD data.

BRIEF DESCRIPTION OF DRAWINGS

   Fig. 1 is a diagram illustrating an example of an overall configuration of a fault detection apparatus according to a first embodiment.
   Fig. 2 is a cross-sectional view illustrating a test apparatus according to the first embodiment.

Fig. 3 is a diagram schematically illustrating CAD data corresponding to a first main surface of a glass epoxy board of the test apparatus according to the first embodiment.

Fig. 4 is an enlarged view of image data of Fig. 3.

Fig. 5 is a diagram schematically illustrating the image data of the test apparatus according to the first embodiment.

Fig. 6 is a diagram schematically illustrating a table relating to characteristics data which is stored in a memory unit according to the first embodiment.

Fig. 7 is a diagram schematically illustrating a table relating to a relation between characteristics data and model data which is stored in the memory unit according to the first embodiment.

Fig. 8 is a flowchart illustrating a test operation of the fault detection apparatus according to the first embodiment.

Fig. 9 is a flowchart illustrating details of Step S5 of Fig. 8.

Fig. 10 is a flowchart illustrating a test operation of a fault detection apparatus of a first modification.

Fig. 11 is a diagram illustrating a table relating to model data which is stored in a memory unit of a fault detection apparatus of a third modification.

Fig. 12 is a flowchart illustrating a test operation of the fault detection apparatus of the third modification.

Fig. 13 is a diagram illustrating a table relating to model data which is stored in a memory unit of a fault detection apparatus according to a second embodiment.

Fig. 14 is a flowchart illustrating a test operation of the fault detection apparatus according to the second embodiment.

Fig. 15 is a diagram illustrating a relation between a distance to a fault and a measurement time of a reflected wave.

DESCRIPTION OF EMBODIMENTS

Hereinafter, embodiments of the invention will be described with reference to the drawings. In the description, the same portions are denoted with the same reference numerals in all the drawings. However, the drawings are schematically illustrated, and it should be noted that relations between thicknesses and planar dimensions, a ratio of thicknesses of layers and the like are different from the practical design. Therefore, the specific thicknesses and dimensions should be determined in consideration of the following description. Further, it is a matter of course that different relations of dimensions and ratios of some portions are included, even among the drawings.

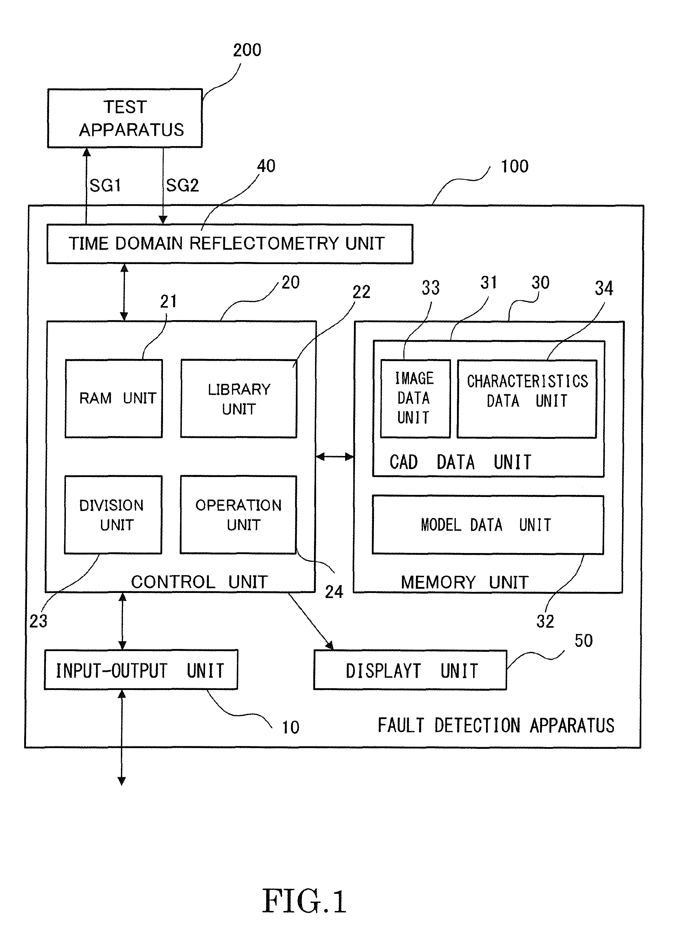

A fault detection apparatus of a first embodiment will be described with reference to Fig. 1. Fig. 1 is a block diagram illustrating a test apparatus and fault detection apparatus of the embodiment. As illustrated in Fig. 1, a fault detection apparatus 100 and a test apparatus 200 are provided. Herein, the description will be made using a BGA semiconductor apparatus as an example of the test apparatus 200, but the invention is not limited to the configuration, and any apparatus may be employed as long as a plurality of electronic components are electrically connected in the apparatus. For example, there can be exemplified an apparatus such as an LGA semiconductor apparatus which is provided with a ball terminal as an external terminal, stacked with semiconductor chips and sealed with resin, and an SSD card or an SD card in which NAND flash memory chips are stacked, or the like.

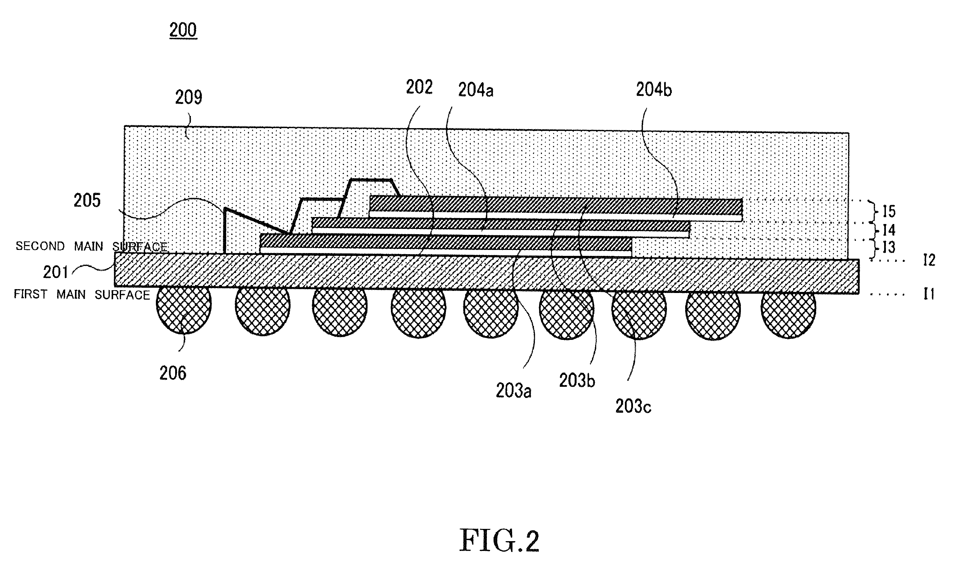

Before describing the fault detection apparatus of the embodiment, the test apparatus will be described with reference to Fig. 2. Fig. 2 is a cross-sectional view illustrating the test apparatus.

As illustrated in Fig. 2, the test apparatus 200 which is the BGA semiconductor apparatus is provided with a glass epoxy board 201, an adhesive layer 202, a first semiconductor chip 203a, a second semiconductor chip 203b, a third semiconductor chip 203c, an adhesive layer 204a, an adhesive layer 204b, a bonding wire 205, a solder ball 206, and a molded resin 209. The first semiconductor chip 203a is disposed on the glass epoxy board 201 through the adhesive layer 202 and bonded to the glass epoxy board 201. The second semiconductor chip 203b is disposed on the first semiconductor chip 203a through the adhesive layer 204a and bonded to the first semiconductor chip 203a. The third semiconductor chip 203c is disposed on the second semiconductor chip 203b through the adhesive layer 204b and bonded to the second semiconductor chip 203b. In the front surface (a first main surface of Fig. 2) of the glass epoxy board 201, a plurality of first electrodes and a plurality of first wirings, each of which is connected to the first electrode, are provided (not illustrated). Each of the first electrodes is connected to the solder ball 206 which is the external terminal. In the back surface of the glass epoxy board 201 (a second main surface opposite to the first main surface of Fig. 2), a plurality of second electrodes and second wirings, each of which is connected to the second electrode, are provided (not illustrated). The second electrode is connected to the corresponding bonding wire 205. The first wiring and the second wiring are connected through a via (not illustrated). The bonding wire 205 connects each of third electrodes provided on the first semiconductor chip 203a, the second semiconductor chip 203b, and the third semiconductor chip 203c to the second electrode. The first semiconductor chip 203a, the second semiconductor chip 203b, the third semiconductor chip 203c, and the bonding wire 205 are sealed with the molded resin 209. A pin number is assigned to each solder ball 206.

The overall configuration of the fault detection apparatus of the first embodiment will be described. As illustrated in Fig. 1, the fault detection apparatus 100 is provided with an input-output unit 10, a control unit 20, a memory unit 30, a time domain reflectometry unit (TDR unit) 40, and a display unit 50. The input-output unit 10 transmits or receives data with respect to the outside. The control unit 20 performs a predetermined arithmetic processing. The memory unit 30 stores various types of data. The time domain reflectometry unit 40 performs a desired measurement by transmitting a high-speed pulse signal to the test apparatus 200 and receiving a measurement signal of a reflected wave, for example. The display unit 50 displays various types of data relating to fault detection, for example.

The input-output unit 10 is connected to the control unit 20. The input-output unit 10 transfers data such as user-input CAD data of the test apparatus 200 to the control unit 20. The input-output unit 10 transfers various types of user-input data to the control unit 20 when the fault detection test of the test apparatus 200 is performed.

The control unit 20 transmits a test result of the test apparatus 200 to the display unit 50. When it is determined that there is a fault in the test apparatus 200, a pointer indicating the fault in image data of the CAD data is displayed in the display unit 50. As a result, an outside user can clearly confirm the fault. Herein, the display unit 50 is provided in the fault detection apparatus 100, but the invention is not necessarily limited to the configuration. The display unit 50 may be provided in the outside of the fault detection apparatus 100. In the case, the user acquires information output from the input-output unit 10 of the fault detection apparatus 100 to confirm the fault in the display apparatus.

In the control unit 20, a RAM unit 21, a library unit 22, a division unit 23, and an operation unit 24 are provided. Herein, the library unit 22 is provided in the control unit 20, but the invention is not necessarily limited to the configuration. For example, the library unit may be provided in the memory unit 30.

The RAM unit 21 stores data such as the CAD data which is transfered from the input-output unit 10. The RAM unit 21 is used as a space where a predetermined calculation is performed. In the CAD data, image data and characteristics data indicating a dimension of each component are included (the details will be described below).

The division unit 23 divides the image data of the CAD data into components included in the test apparatus 200. The divided data relating to the components is stored in the library unit 22. The division unit 23 has access to the library unit 22 after the CAD data is read to the RAM unit 21, and divides the CAD data into the components.

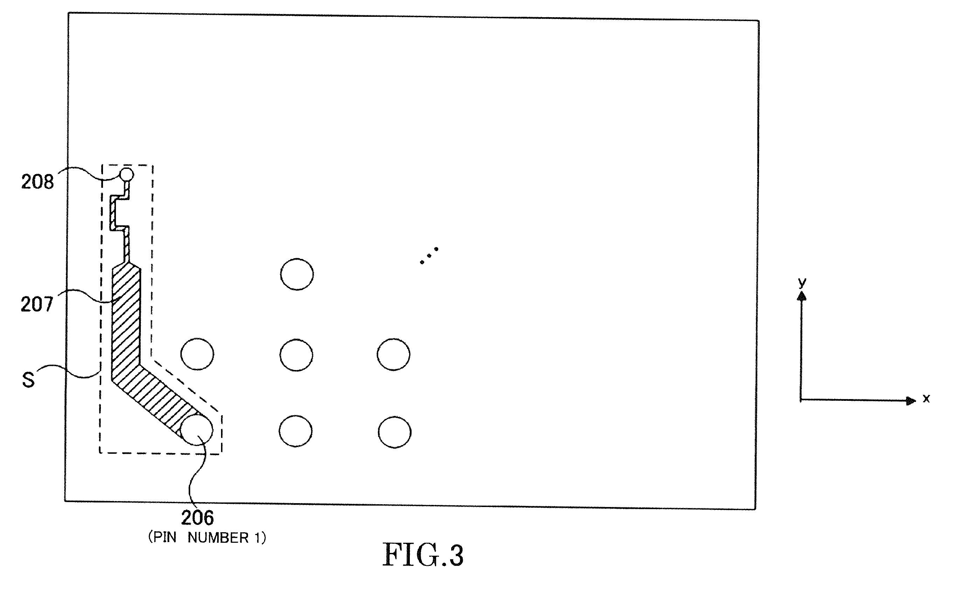

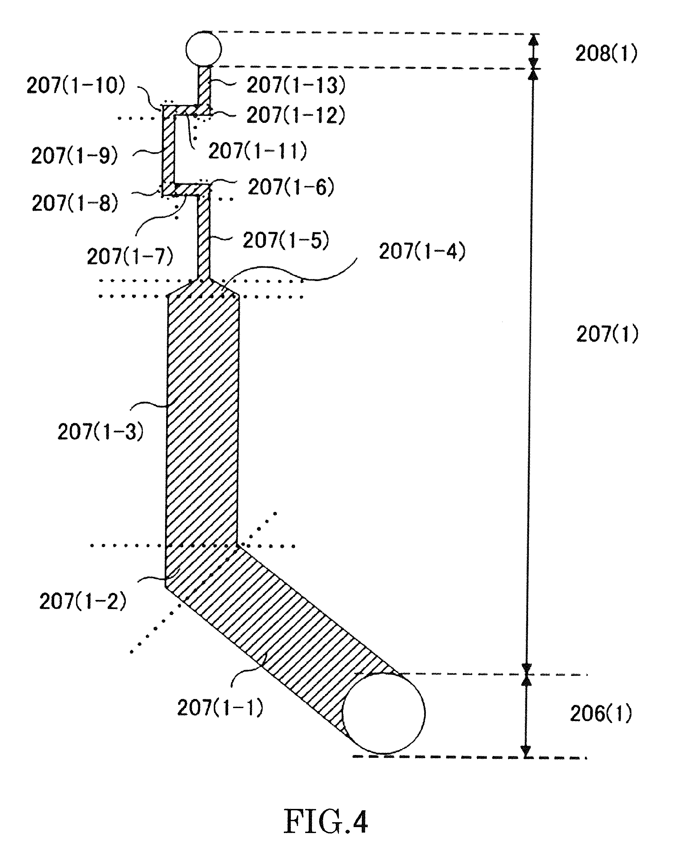

A specific example of the CAD data will be described with reference to Figs. 3 and 4. Fig. 3 is a diagram schematically illustrating the CAD data which corresponds to the first main surface of the glass epoxy board of the test apparatus. Fig. 4 is an enlarged view of the image data of Fig. 3.

As illustrated in Fig. 3, when the division unit 23 divides the image data S connected to the solder ball 206(1) having Pin number 1 as a component in the first main surface of the glass epoxy board 201, the division unit 23 has access to the library unit 22, and divides the image data S into the solder ball 206(1) having Pin number 1, a first wiring 207(1) connected to the solder ball 206(1), and a via 208(1) as illustrated in Fig. 4 based on data relating to each component.

The division unit 23 divides the component into portions for each characteristic of the component when the characteristics of the component are changed in the middle of the portions. For example, as illustrated in Fig. 4, the first wiring 207(1) is changed in width in the middle of the wiring, and bent in the middle of the wiring. The division unit 23 divides the first wiring into a first portion 207(1-1), a second portion 207(1-2), ..., and a thirteenth portion (2-13) according to the characteristics of the first wiring 207(1).

In the library unit 22, data indicating a determination reference for dividing the component into portions is stored. For example, in a case where the component is a wiring, the wiring is divided when the width of the wiring is changed. Further, the wiring is divided when the wiring is bent (for example, 207(1 to 6)).

In the above division method, the division is made when a resistance value is changed per unit length. As long as the resistance value is not changed per unit length, the component is considered as one part without division. As the width of the wiring is changed, the resistance value is changed per unit length, so that the division is made. Similarly, in a case where the wiring is bent in the middle of the wiring, the resistance value is changed per unit length, so that the division is made. In addition, methods other than the above division method may be employed.

The control unit 20 outputs the image data of the CAD data and the characteristics data of each divided component or portion to the memory unit 30. In addition, the invention is not limited to the above case, and the image data and the characteristics data of the CAD data for each divided component or portion may be output to the memory unit 30 for example.

In the fault detection test, the operation unit 24 recognizes a component or a portion corresponding to the solder ball on which the fault detection test is performed, reads out the model data for each component or portion to the RAM unit 21, and calculates a fault corresponding to the component or the portion by applying data output from the time domain reflectometry unit 40 to the model data, so that the fault is specified. In addition, the details will be described below.

In the memory unit 30, a CAD data unit 31 and a model data unit 32 are provided. In the CAD data unit 31, an image data unit 33 and a characteristics data unit 34 are provided. The characteristics data of the CAD data is stored in the characteristics data unit 34 for each component included in the test apparatus 200 or for each of the plurality of portions obtained by dividing the component. The image data of the CAD data may be stored in the image data unit 33 as a whole, or the image data of the CAD data may be stored in the image data unit 33 for each component or portion.

The above-mentioned data is data for specifying the fault in the component or the portion in a nondestructive manner, or may be data for presenting the fault in the component or the portion to the user.

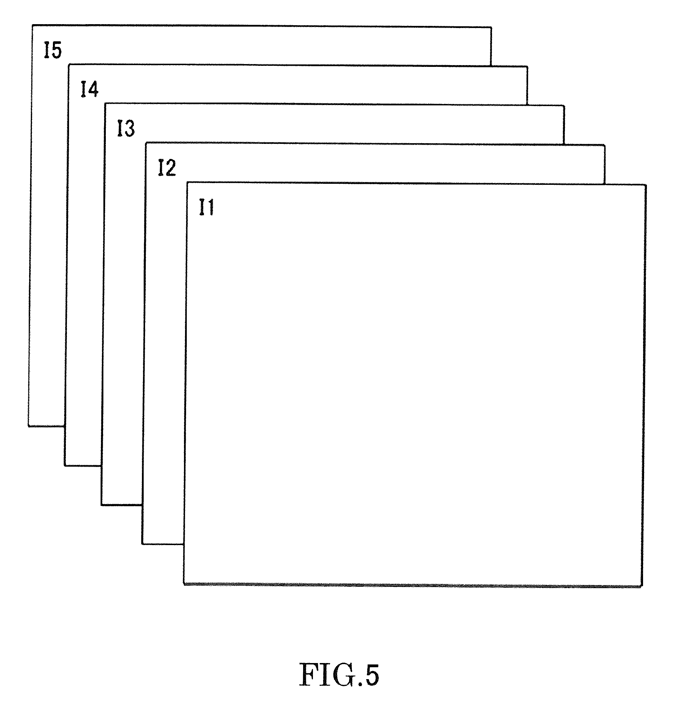

The memory unit 30 stores the image data and the characteristics data for each component or portion whenever the CAD data is output from the input-output unit 10. The image data will be described with reference to Fig. 5. Fig. 5 is a diagram schematically illustrating the image data. As illustrated in Fig. 5, for example, in a case where the test apparatus 200 is the BGA semiconductor apparatus (illustrated in Fig. 2), five pieces of image data I1 to I5 are stored in the image data unit 33, characteristics data D1 to D5 of components or portions which correspond to the image data I1 to I5 are stored in the characteristics data unit 34.

The image data I1 is image data relating to the first main surface of the glass epoxy board 201. The image data I1 is the image data of the first electrode, the first wiring, and the via which are formed in the first main surface of the glass epoxy board 201. The characteristics data D1 is the characteristics data of the first electrode, the first wiring, and the via (data indicating a layout position, data indicating a length, data indicating a width, data indicating a slope with respect to a reference line, data indicating a shape, material data, and the like).

The image data I2 is image data relating to the second main surface which is opposite to the first main surface of the glass epoxy board 201. The image data I2 is image data of the second electrode, the second wiring, and the via which are formed in the second main surface of the glass epoxy board 201. The characteristics data D2 is the characteristics data of the second electrode, the second wiring, and the via (data indicating a layout position, data indicating a length, data indicating a width, data indicating a slope with respect to a reference line, data indicating a shape, material data, and the like).

The image data I3 to I5 are image data relating to the first semiconductor chip 203a, the second semiconductor chip 203b, and the third semiconductor chip 203c. The image data I3 to I5 are image data of wirings connected to the third electrodes of the first semiconductor chip 203a, the second semiconductor chip 203b, and the third semiconductor chip 203c, or image data of electronic components in the first semiconductor chip 203a, the second semiconductor chip 203b, and the third semiconductor chip 203c. The characteristics data D3 to D5 are the characteristics data of wirings or electronic components (data indicating a layout position, data indicating a length, data indicating a width, data indicating a slope with respect to a reference line, data indicating a shape, material data, and the like).

In the embodiment, the memory unit 30 stores the image data I1 to I5 and the characteristics data D1 to D5 for each component or portion corresponding to the image data I1 to I5. For example, in a case where the image data I1 to I5 can be reproduced by the characteristics data D1 to D5, only the characteristics data D1 to D5 may be stored in the memory unit 30 instead. In the embodiment, in a case where the component is a wiring, data indicating a layout position of the component or the portion, data indicating a length, data indicating a width, data indicating a slope with respect to a reference line, and data indicating a shape are exemplified as the characteristics data, but the invention is not limited to these characteristics. Further, any data may be used as long as data can specify the wiring or a portion of the wiring. As the characteristics data of the solder ball and the via, data indicating a circular shape, data indicating a diameter (data indicating a first diameter, data indicating a second diameter), and data indicating a material are exemplified. Further, any data may be used as long as data specifies the component such as the solder ball and the portion of the component.

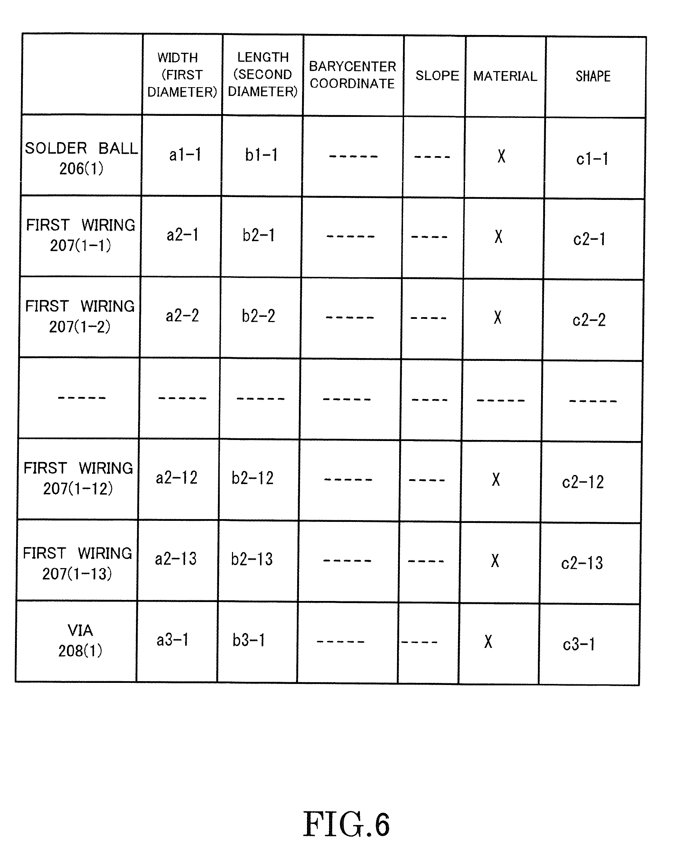

An example of the characteristics data will be described with reference to Fig. 6. Fig. 6 is a diagram schematically illustrating a table relating to the characteristics data which is stored in the memory unit of the embodiment. Herein, the characteristics data is stored in the memory unit 30 in a table format.

As illustrated in Fig. 6, specific data indicating a width (or the first diameter), a length (or the second diameter), gravity center coordinates, a slope with respect to the reference line, a material, and a shape is associated with each component or portion. The widths (or the first diameters) of the solder ball 206(1), the first wirings 207(1-1) to 207(1-13), and the via 208(1) are set to a1-1, a2-1 to a2-13, and a3-1, respectively. The lengths (or the second diameters) are set to b1-1, b2-1 to b2-13, and b3-1, respectively. The shapes are set to c1-1, c2-1 to c2-13, and c3-1, respectively. The materials of the solder ball 206(1), the first wirings 207(1-1) to 207(1-13), and the via 208(1) are all X (for example, copper (Cu)).

The memory unit 30 stores the model data in the model data unit 32 as well as the image data of the CAD data and the characteristics data of each component or portion. Herein, the model data is data (for example, function data) which is obtained by modeling a conductivity characteristic of a pulse wave for each component or portion. The modeled data is used for specifying a fault point in a component or a portion based on data output from the time domain reflectometry unit 40 to be described below, the image data, and the characteristics data.

The model data is stored in the model data unit 32 of the memory unit 30 in advance before the fault detection test is performed by the time domain reflectometry unit 40. A method of calculating the model data will be described below.

The model data corresponding to the characteristics data of each component or portion is stored in the model data unit 32.

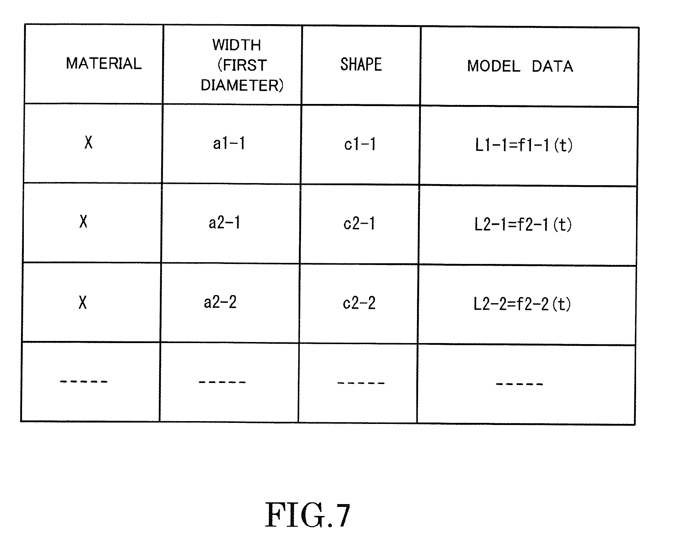

The description will be made using the table with reference to Fig. 7. Fig. 7 is a diagram schematically illustrating a relation between the characteristics data and the model data which are stored in the memory unit of the embodiment.

As illustrated in Fig. 7, for example, when the characteristics data includes a material X, a width a2-1, and a shape c2-1, model data L2-1 is expressed as follows,

$$L2\text{-}1 = f2\text{-}1(t) \qquad \text{Equation (1)}.$$

Herein, the model data L2-1 represents a predicted conduction distance over which a pulse wave is advanced while a time t elapses after the pulse wave is input from an end of a wiring (or a part of the wiring) having the material X, the width a2-1, and the shape c2-1 until the pulse wave is conducted to the other end of the wiring (or a part of the wiring).

In Fig. 7, only three types of model data are disclosed, but the model data corresponding to all the components and portions used in the test apparatus 200 is stored in the model data unit 32. However, in a case where there are a plurality of wirings having the material X, the width a2-1, and the shape c2-1 (straight line) but are different in length, and in a case where the conductivity characteristic of the pulse wave is the same, it is desirable to use common model data. In the case, it is possible to suppress an increase in model data to be stored.

In the embodiment, the model data corresponding to all the components and portions used in the test apparatus 200 is stored in the model data unit 32. However, in a case where the test object is set in advance, only the model data corresponding to the component and the portion may be stored in the model data unit 32.

A function f2-1(t) is a function having a positive correlation with time t. For example, the function f2-1(t) is a linear function such as f2-1(t) = {(A2-1)*t} + (B2-1). Herein, A2-1 is larger than zero (0). A2-1 and B2-1 are integers which are determined based on the material X, the width a2-1, and the shape c2-1.

The model data f1-1(t), f2-1(t), and so on are each stored in the memory unit 30 in association with the characteristics data. In addition, in the embodiment, the model data is each stored in the memory unit 30 in association with the characteristics data, but may be stored in the memory unit 30 in association with each component or portion.

Next, the time domain reflectometry unit 40 will be described using Fig. 1. As illustrated in Fig. 1, the time domain reflectometry unit 40 is connected to the control unit 20 and the test apparatus 200. For example, in the time domain reflectometry unit 40, a pulse generator, an oscilloscope, and a probe (not illustrated) are provided. The probe abuts on the solder ball of the test object.

As the time domain reflectometry unit 40, a time domain reflectometry (TDR) apparatus in which a pulse wave is used is employed, for example. The pulse wave is a high-speed pulse signal which is generated from the pulse generator.

When a signal to start the fault detection test is received from the control unit 20, the time domain reflectometry unit 40 transmits a high-speed pulse signal SG1 to the test apparatus 200 through the probe, for example. In a case where there is a fault (such as disconnection or scratches of a wiring) in the wiring connected to the solder ball of the test object of the test apparatus 200, the high-speed pulse signal SG1 is reflected at the fault. The time domain reflectometry unit 40 receives the reflected pulse as a reflection signal SG2. The time domain reflectometry unit 40 measures a reflected-wave measurement time which is a time taken until the reflection signal SG2 is received after the high-speed pulse signal SG1 is transmitted.

The time domain reflectometry unit 40 outputs the data of the reflected-wave measurement time thus measured to the control unit 20.

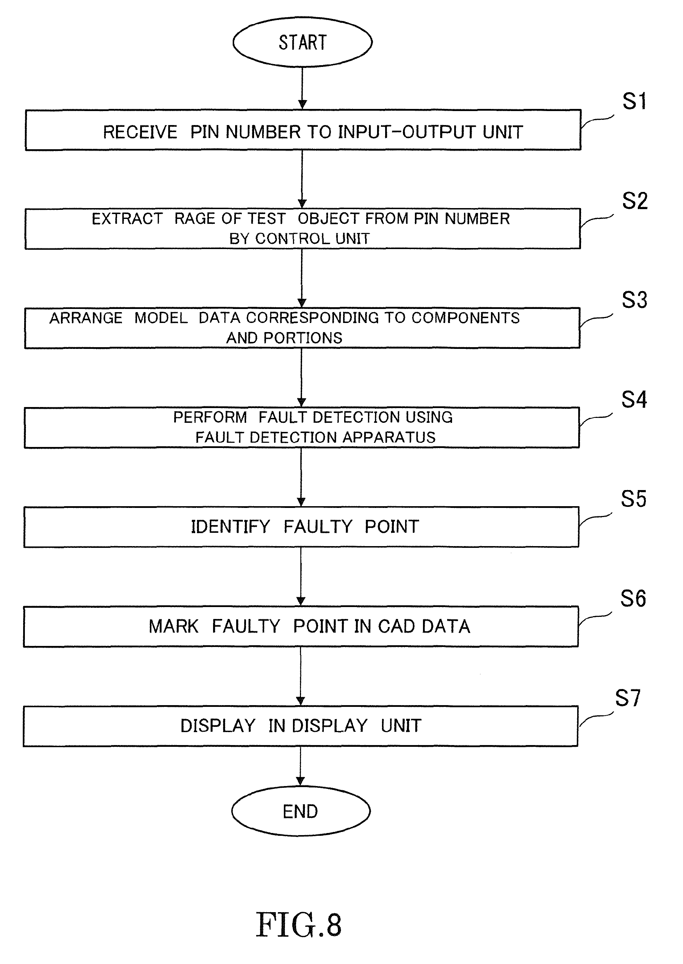

Next, a test operation of the fault detection apparatus will be described with reference to Fig. 8. Fig. 8 is a flowchart illustrating the test operation of the fault detection apparatus.

In the test operation of the fault detection apparatus of the embodiment, the characteristics data of the CAD data for each component of the test object of the test apparatus 200 or for each of a plurality of portions obtained by dividing the component is stored in the characteristics data unit 34. After the model data of each component or portion is stored in the model data unit 32, the fault test of the test apparatus 200 is performed.

Before describing a specific test method of the fault detection apparatus, an example of calculating the model data will be described. The model data is determined by measuring a conductivity characteristic for each component or portion. Specifically, for example, the conductivity characteristic of the wiring is measured as follows.

Two wirings having the same characteristics are prepared. One wiring is made to have a fault at a point separated by Distance LL1 from an end of the wiring. The other wiring is made to have a fault at a point separated by Distance LL2 (> LL1) from the end of the wiring. For example, the probe of the time domain reflectometry unit 40 is connected to the end of the one wiring, and a first pulse wave is output to the one wiring. The time domain reflectometry unit 40 measures Time TT1 taken until the reflected first pulse wave is received after the first pulse wave is output. Similarly, for example, the probe of the time domain reflectometry unit 40 is connected to one end of the second wiring, and a second pulse wave is output to the second wiring. The time domain reflectometry unit 40 measures Time TT2 taken until the reflected second pulse wave is received after the second pulse wave is output.

The model data is determined based on Time TT1, Time TT2, Distance LL1, and Distance LL2. It is possible to determine a high-accuracy model data by increasing the number of samples.

Performing the above works repeatedly, the model data of each determined component or portion is stored in the model data unit 32.

The test operation of the fault detection apparatus of the embodiment will be described with reference to Fig.

8. Fig. 8 is a flowchart illustrating the test operation of the fault detection apparatus. Herein, the characteristics data of the CAD data of each component of the test apparatus 200 or each of a plurality of portions obtained by dividing the component is stored in the characteristics data unit 34 in advance. The image data of the CAD data is stored in the image data unit 33 in advance. The model data corresponding to all the components and portions used in the test apparatus 200 is stored in the model data unit 32 in advance.

First, when a pin number of a solder ball of the test object is acquired in Step S1, the input-output unit 10 outputs the pin number to the control unit 20. Further, when information data such as a material of a solder resist, a material of a wiring, a material and a size of a solder ball, and a height of a wiring (a height in a direction perpendicular to a plan on which the wiring is extended) is acquired as well as the pin number, the input-output unit 10 outputs these pieces of information data to the control unit 20. In addition, the model data may be extracted based on these pieces of information data in Step S3 described below.

Next, in Step S2, the operation unit 24 sets a range electrically connected to the solder ball of the selected pin number as the test object, and extracts the range of the test object from the CAD data. For example, in a case where the test apparatus 200 is the BGA semiconductor apparatus, the operation unit 24 specifies the first electrode, the first wiring, and the via which are connected to the solder ball of the test object from the image data I1, and includes these components into the range of the test object.

The operation unit 24 specifies the second wiring and the second electrode which are connected to the via included in the range of the test object in the image data I1, from the image data I2, and includes the second wiring and the second electrode into the range of the test object. Similarly, electronic components of the first semiconductor chip 203a, the second semiconductor chip 203b, and the third semiconductor chip 203c which are connected through the bonding wire 205 in the range of the test object of the image data I2 in the first semiconductor chip 203a, the second semiconductor chip 203b, and the third semiconductor chip 203c are specified from the image data I3 to I5, and these components are included in the range of the test object.

Subsequently, in Step S3, the operation unit 24 reads out the model data corresponding to the components and the portions included in the range of the test object to be arranged in a conducting order of the pulse wave, to the data in the RAM unit 21. Specifically, the operation unit 24 reads out the characteristics data corresponding to the components and the portions included in the range of the test object out of the table listed in Fig. 6, to the data in the RAM unit 21. The operation unit 24 arranges the components and the portions included in the test object in the conducting order of the pulse wave. The operation unit 24 has access to the table listed in Fig. 7 to read out the model data corresponding to the characteristics data of the components and the portions, to the model data in the RAM unit 21. The operation unit 24 arranges the model data in the RAM unit 21 in the conducting order of the pulse wave.

Then, in Step S4, the control unit 20 outputs a signal to start the fault detection test to the time domain reflectometry unit 40. Therefore, the fault detection test is performed. The time domain reflectometry unit 40 brings the probe into contact with the solder ball of the test object of the test apparatus 200. The time domain reflectometry unit 40 outputs the high-speed pulse signal SG1 to the test apparatus 200 through the probe. The time domain reflectometry unit 40 measures a time taken until the reflected pulse wave is received as the reflection signal SG2 after the high-speed pulse signal SG1 is output. The time domain reflectometry unit 40 outputs the measured Time T1 as data to the control unit 20.

Next, in Step S5, the control unit 20 specifies a fault based on the model data which is obtained in the conducting order of the pulse wave in Step S3, and Time T1 acquired in Step S4.

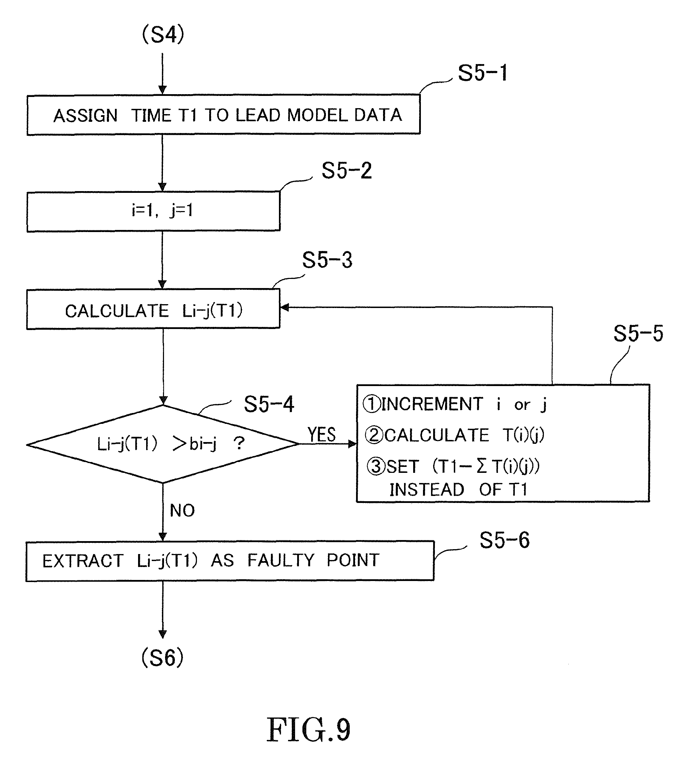

A specific method of specifying the fault will be described with reference to Fig. 9. Fig. 9 is a flowchart illustrating the details of Step S5 of Fig. 8. Herein, the pin number of the solder ball of the test object is "1", and the fault is in the first wiring 207(1-3). The model data obtained in Step S3 in the conducting order of the pulse wave and the characteristics data of length are information as follows.

In the solder ball 206(1), the model data is represented by $L1\text{-}1 = f1\text{-}1(t)$, and the length (the second diameter) is set to b1-1. In the first wiring 207(1-1), the model data is represented by $L2\text{-}1 = f2\text{-}1(t)$, and the length (the second diameter) is set to b2-1. In the first wiring 207(1-2), the model data is represented by $L2\text{-}2 = f2\text{-}2(t)$, and the length (the second diameter) is set to b2-2. In the first wiring 207(1-3), the model data is represented by $L2\text{-}3 = f2\text{-}3(t)$, and the length (the second diameter) is set to b2-3. Similarly, in the first wiring 207(1-12), the model data is represented by $L2\text{-}12 = f2\text{-}12(t)$, and the length (the second diameter) is set to b2-12. In the first wiring 207(1-13), the model data is represented by $L2\text{-}13 = f2\text{-}13(t)$, and the length (the second diameter) is set to b2-13. The subsequent descriptions are omitted.

Herein, in the following steps, the control unit 20 specifies a fault. As illustrated in Fig. 9, in Step S5-1, the operation unit 24 substitutes Time T1 into the model data at the head position in the model data arranged in the order.

Next, in Step S5-2, the operation unit 24 sets i = 1 and j = 1. Parameters i and j shown herein mean that a distance is expressed as Li-j for example.

Subsequently, in Step S5-3, the operation unit 24 calculates Distance $Li\text{-}j(T1)$ by the model data in which Time T1 is substituted.

Then, in Step S5-4, the operation unit 24 compares Distance $Li\text{-}j(T1)$ with the characteristics data bi-j of the length.

In a case where it is determined that Distance Li-j(T1) is larger than the characteristics data bi-j of the length, the process of Step S5-5 is performed. Specifically, j is increased. However, when j reaches a maximum value, i is increased. When i is increased, j is set to an initial value (j = 1). In addition, i and j are set by the division unit 23 when the image data is divided. Then, i and j are stored in the fault detection apparatus 100. The operation unit 24 calculates Time T(i)(j) which satisfies the following Equation (2).

$$Li\text{-}j(T(i)(j)) = bi\text{-}j \qquad \text{Equation (2)}$$

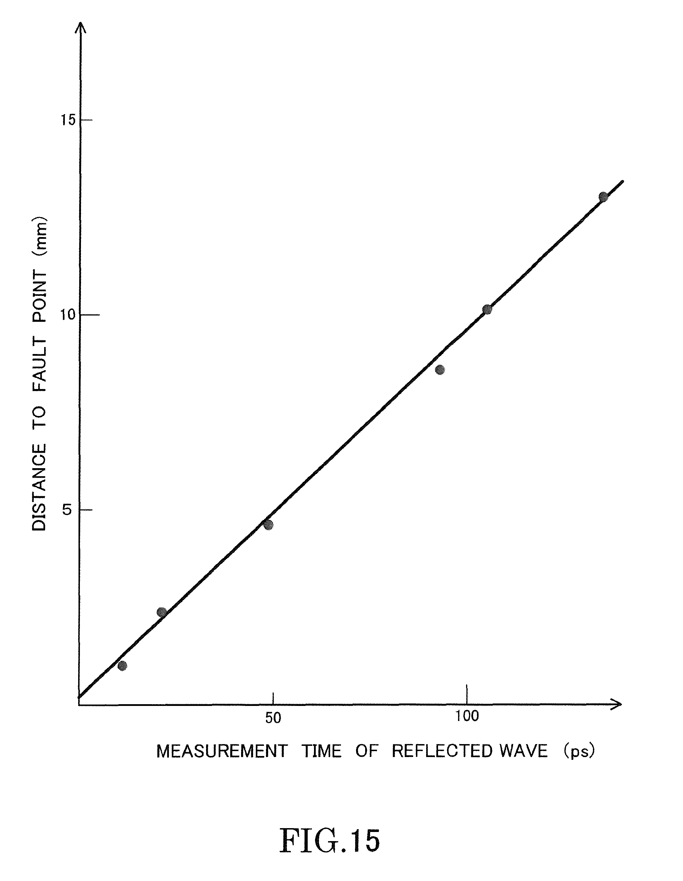

The operation unit 24 calculates Time T1 - $\sum$T(i)(j) {that is, a time obtained by adding a total sum of T(1)(j) for all j, a total sum of T(2)(j) for all j, ..., a total sum of T(i-1)(j) for all j, and a total sum of T(i)(1) to T(i)(j-1)}. Herein, it is assumed that T11 = 0. The operation unit 24 sets Time T1-$\sum$Tij instead of Time T1 (Step S5-5), and returns to Step S5-3.
In a case where Distance Li-j(T1) is smaller than the characteristics data bi-j of the length, the operation unit 24 detects Distance Li-j(T1) as the fault (Step S5-6), and proceeds to Step S6.
The details of the subsequent operations of Step S5-3 will be described using the above example. The operation unit 24 calculates Distance L1-1(T1), and compares Distance L1-1(T1) with the characteristics data b1-1 of the length (Step S5-4). In a case where Distance L1-1(T1) is large, the operation unit 24 increases i to be i = 2 and sets j = 1, and calculates T(1)(1) (Step S5-5). Then, the procedure returns to Step S5-3, and the operation unit 24 calculates Distance L2-1(T1-T(1)(1)) by the model data in which Time T1-T(1)(1) is substituted (Step S5-3). The operation unit 24 compares L2-1(T1-T(1)(1)) with b2-1 (Step S5-4). In a case where Distance L2-1(T1-T(1)(1)) is large, the operation unit 24 increases j to be i = 2 and sets j = 2, and calculates T(1)(1) + T(2)(1) (Step S5-5). Then, the procedure returns to Step S5-3, and the operation unit 24 calculates Distance L2-1(T1 - T(1)(1) - T(2)(1)) by the model data in which a time {T1-T(1)(1) - T(2)(1)} is substituted (Step S5-3).
The operation unit 24 compares Distance L2-1(T1 - T(1)(1) - T(2)(1)) with b2-2 (Step S5-4). In a case where Distance L2-1(T1 - T(1)(1) - T(2)(1)) is small, the operation unit 24 detects Distance L2-1(T1 - T(1)(1) - T(2)(1)) as the fault (Step S5-6), and ends the procedure.
Next, in Step S6, the control unit 20 reads out the image data of the CAD data in the memory unit 30 to the data in the RAM unit 21, and marks the position of the fault detected in Step S5 on the image data. The control unit 20 outputs the image data with the fault marked to the display unit 50.
Then, in Step S7, the control unit 20 outputs the image data with the fault marked to the display unit 50. The display unit 50 receives and displays the image data with the fault marked.
As a result, the fault detection apparatus of the embodiment can detect the fault of the test apparatus with a high accuracy. Hereinafter, advantages of the embodiment will be specifically described using a comparative example in which the fault of the test apparatus is specified by the time domain reflectometry (TDR) apparatus.
In a case where the apparatus of the comparative example specifies a fault of the test apparatus, even when a time taken until a pulse wave is transmitted to the test apparatus and the reflected pulse is received is measured, the apparatus of the comparative example is not capable of determining a position of the fault by the measured time. In a case where the test apparatus is a BGA semiconductor apparatus, it is difficult to determine whether there is a fault in the wiring of the glass epoxy board, and whether there is a fault in the wiring in the semiconductor chip.
On the other hand, in the embodiment, the control unit 20 divides the components from each other or into portions based on the CAD data, reads out the model data of each divided component or portion, and specifies the fault by performing a desired calculation. As a result, it is possible to detect whether there is a fault in a part separated from the components and the portions as well as it is possible to detect whether there is a fault in the divided component or portion by a predetermined distance.
An exemplary result of the reflected-wave measurement time using the time domain reflectometry unit 40 will be described with reference to Fig. 15. Fig. 15 is a diagram illustrating a relation between a distance to the fault and the reflected-wave measurement time. As illustrated in Fig. 15, a relation between the distance (L) to the fault of the test apparatus and the first time period (t) which is the reflected-wave measurement time is expressed as follows,

$$L = (C_o \times t)/\{2 \times \varepsilon_{ef}^{(1/2)}\} + A \qquad \text{Equation (3)}$$

(where, Co is a light speed, $\varepsilon_{ef}$ is an effective relative dielectric constant, and A is a constant). Equation (3) is expressed in a linear function.
An effective relative dielectric constant of 3.0 is calculated from the slope of the straight line illustrated in Fig. 15.
In a case where the test apparatus is made of a plurality of materials, for example, a distance (L) to the fault of the test apparatus is calculated by substituting a distance ($\Delta L$) of the material, a measurement time ($\Delta t$) of the reflected wave, and a relative dielectric constant ($\Delta\varepsilon_{ef}$) into the above Equation (3) to obtain the total sum. Therefore, the fault can be specified. As a result, even in a case where the test apparatus is made of the plurality of materials, the fault detection apparatus of the embodiment can detect the fault of the test apparatus with a high accuracy.

Next, a fault detection apparatus of a first modification will be described. The fault detection apparatus of the first modification is differently configured from the fault detection apparatus of the first embodiment in that the model data and the table shown in Fig. 7 are stored in the memory unit 30 and the image data of the CAD data and the characteristics data are not stored in the memory unit 30. The other configurations are the same, and thus the details will not be repeated.

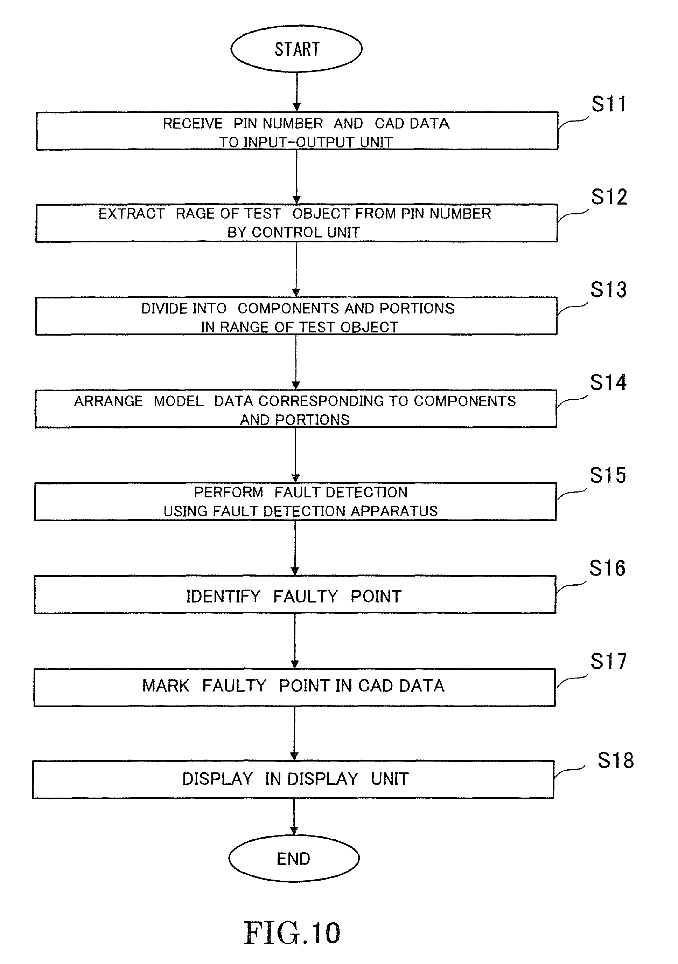

A test operation of the fault detection apparatus of the first modification will be described with reference to Fig. 10. Fig. 10 is a flowchart illustrating the test operation of the fault detection apparatus of the first modification. Herein, the model data corresponding to all the components and parts used in the test apparatus 200 is stored in the memory unit 30 in advance.

First, in Step S11, when receiving the pin number of the solder ball of the test object and the CAD data (the image data and the characteristics data), the input-output unit 10 outputs the pin number and the CAD data to the control unit 20. In Step S11, information data such as a material of a solder resist, a material of a wiring, a material and a size of the solder ball, a height of a wiring (a height in a direction perpendicular to a plan on which the wiring is extended) is acquired besides the pin number and the CAD data, the input-output unit 10 outputs the information data to the control unit 20. In addition, the model data may be extracted based on the information data in Step S14 described below to be arranged.

Next, in Step S12, the operation unit 24 of the control unit 20 stores the CAD data in the RAM unit 21, and sets a range electrically connected to the solder ball of the selected pin number as the test object, and extracts the range of the test object from the CAD data. A method of extracting the range of the test object is the same as that in Step S2 of the first embodiment.

Subsequently, in Step S13, the division unit 23 divides the range of the test object into components and portions in the RAM unit 21 based on the data stored in the library unit 22. The division unit 23 divides only the range of the test object into the components or portions, and does not divide the test object in the outside of the range.

Then, in Step S14, the operation unit 24 has access to the table listed in Fig. 7, and arranges the model data corresponding to the components and parts included in the range of the test object in the conducting order of the pulse wave.

Next, in Step S15, the control unit 20 outputs a signal to start the fault detection test to the time domain reflectometry unit 40. Therefore, the fault detection test is performed. The time domain reflectometry unit 40 brings the probe into contact with the solder ball of the test object of the test apparatus 200. The time domain reflectometry unit 40 measures the reflected-wave measurement time which is a time taken until the reflection signal (the reflected pulse wave) SG2 is received after the high-speed pulse signal SG1 is transmitted to the test apparatus 200 through the probe. The time domain reflectometry unit 40 outputs the measured Time T2 as information data to the control unit 20.

Subsequently, in Step S16, the control unit 20 specifies a fault based on the model data in the conducting order of the pulse wave obtained in Step S3 and Time T2 obtained in Step S5.

Then, in Step S17, the control unit 20 marks the fault on the image data of the CAD data in the RAM unit 21. The control unit 20 outputs the image data with the fault marked to the display unit 50.

Next, in Step S18, the display unit 50 receives and displays the image data with the fault marked. As a result, similarly to the first embodiment, the fault detection apparatus of the first modification can detect the fault of the test apparatus with a high accuracy.

Further, the fault detection apparatus of the first modification can make the size of the memory unit 30 smaller than that of the first embodiment. Further, in the fault detection apparatus of the first modification, in Step S13 of the test operation, the division unit 23 divides only the range of the test object into the components or portions, and does not divide the test object in the outside of the range. Thus, it is possible to perform the fault detection test without dividing all the components or portions of the test apparatus. Therefore, with the test operation of the first modification, a test can be finished in a short time compared to the test operation of the first embodiment.

Next, a fault detection apparatus of a second modification will be described. The fault detection apparatus of the second modification has the same configuration as that of the fault detection apparatus of the first embodiment. The second modification is different from the test operation of the first embodiment in that Steps S2 and S3 of the test operation of the first embodiment are performed in parallel with Step S4. The other processes of the test operation are similar, and thus the details will not be repeated. After it is detected that both Steps S3 and S4 are completed, the control unit 20 proceeds to Step S5.

As a result, the fault detection apparatus of the second modification can detect the fault of the test apparatus with a high accuracy similarly to the first embodiment.

Further, in the fault detection apparatus of the second modification, Steps S2 and S3 of the test operation of the first embodiment are performed in parallel with Step S4. Therefore, with the test operation of the second modification, a test can be finished in a short time compared to the test operation of the first embodiment.

In addition, the second modification can also be applied to the first modification. In the case, the test can be performed in a still shorter time than that in the first modification.

Next, a fault detection apparatus of a third modification will be described. The fault detection apparatus of the third modification is different from the fault detection apparatus of the first embodiment in that a time for conducting the pulse wave from one end to the other end of a component or portion is stored in the memory unit 30 for each component or portion. The other configurations are the same, and thus the detailed description will not be repeated.

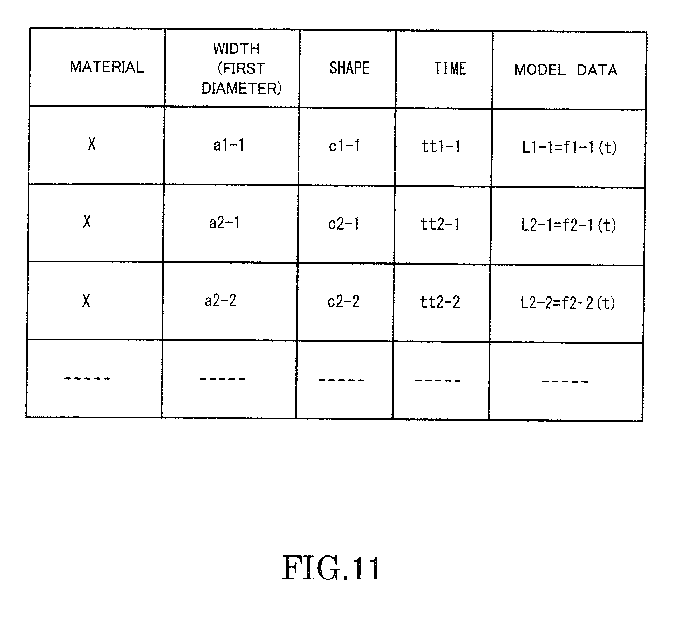

The time for conducting the pulse wave from the one end to the other end of the component or portion will be specifically described with reference to Fig. 11. Fig. 11 is a diagram illustrating a table relating to the model data stored in the memory unit of the fault detection apparatus of the third modification.

As illustrated in Fig. 11, for example, when the characteristics data includes the material X, the width a2-1, and the shape c2-1, the model data L2-1 satisfies Equation (1) described in the first embodiment.

Herein, the model data L2-1 represents a predicted conduction distance over which a pulse wave is advanced while a time t elapses after the pulse wave is input from an end of a wiring (or a portion of the wiring) having the material X and the shape c2-1 until the pulse wave is conducted to the other end of the wiring (or a portion of the wiring).

The function f2-1(t) is a function having a positive correlation with time t. The model data f1-1(t), f2-1(t), and so on are each stored in the memory unit 30 in association with the characteristics data. In addition, in the embodiment, the model data is each stored in the memory unit 30 in association with the characteristics data, but may be stored in the memory unit 30 in association with each component or portion.

For example, a time tt2-1 for conducting the pulse wave from the one end to the other end of the component or portion is stored in the memory unit 30 in association with the model data L2-1.

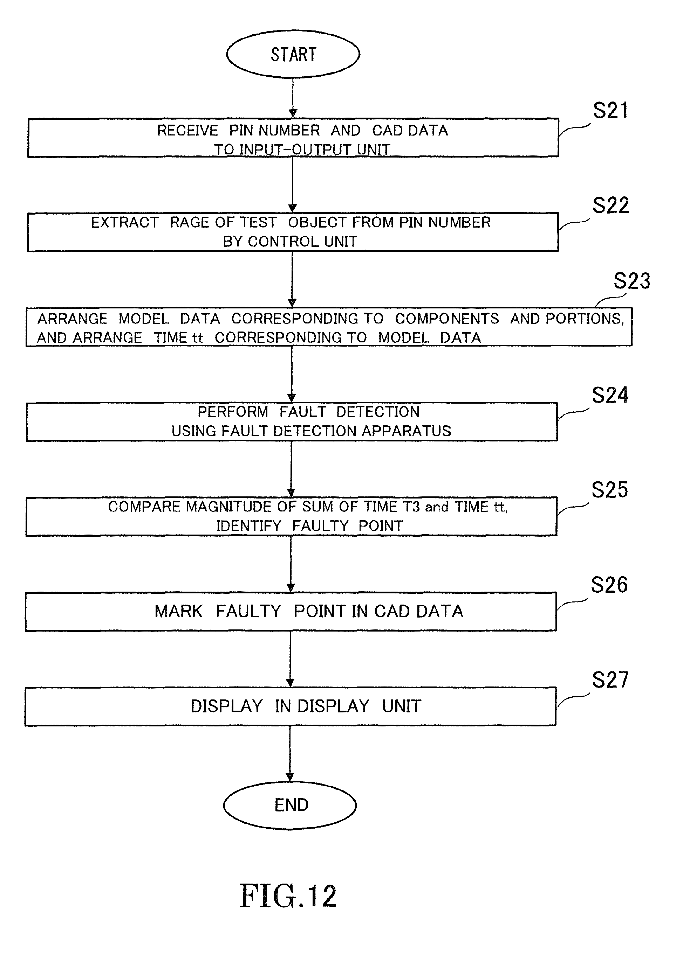

Next, the fault detection apparatus of the third modification will be described with reference to Fig. 12. Fig. 12 is a flowchart illustrating a test operation of the fault detection apparatus of the third modification. Herein, the characteristics data of the CAD data of each component of the test apparatus 200 or each of a plurality of portions obtained by dividing the component is stored in the characteristics data unit 34 in advance. The image data of the CAD data is stored in the image data unit 33 in advance. The model data corresponding to all the components and portions used in the test apparatus 200 is stored in advance.

First, when a pin number of a solder ball of the test object is acquired in Step S21, the input-output unit 10 outputs the pin number to the control unit 20. In Step S21, when information data such as a material of a solder resist, a material of a wiring, a material and a size of a solder ball, and a height of a wiring (a height in a direction perpendicular to a plan on which the wiring is extended) is acquired as well as the pin number, the input-output unit 10 outputs the information data to the control unit 20.

Next, in Step S22, the operation unit 24 of the control unit 20 sets a range electrically connected to the solder ball of the selected pin number as the test object, and extracts the range of the test object from the CAD data.

Subsequently, in Step S23, the operation unit 24 reads out the model data corresponding to the components and the portions included in the range of the test object to be arranged in a conducting order of the pulse wave, to the data in the RAM unit 21. At the time, Time tt for conducting the pulse wave from the one end to the other end of the component or portion corresponding to the model data is read out to the RAM unit 21. Times tt are arranged in the conducting order of the pulse wave.

Then, in Step S24, the control unit 20 outputs a signal to start the fault detection test to the time domain reflectometry unit 40. Therefore, the fault detection test is performed. The time domain reflectometry unit 40 brings the probe into contact with the solder ball of the test object of the test apparatus 200. The time domain reflectometry unit 40 measures the reflected-wave measurement time which is a time taken until the reflection signal (the reflected pulse wave) SG2 is received after the high-speed pulse signal SG1 is transmitted to the test apparatus 200 through the probe. The time domain reflectometry unit 40 outputs a measured Time T3 as information data to the control unit 20.

Next, in Step S25, the control unit 20 specifies a fault based on the model data in the conducting order of the pulse wave obtained in Step S23, Time tt, and Time T3 obtained in Step S24.

When specifying the fault, the control unit 20 compares Time T3 with Time (tt1-1) for conducting the pulse wave from the one end to the other end of the component or portion corresponding to the model data at the head position. In a case where Time T3 is larger than Time (tt1-1), the control unit 20 reads out Time tt2-1 corresponding to the next model data to the read time in the RAM unit 21, and compares Time T3 with Time {(tt1-1) + (tt2-1)}.

In a case where Time T3 is larger than Time {(tt1-1) + (tt2-1)}, the control unit 20 reads out Time (tt2-2) corresponding to the next model data to the read time in the RAM unit 21. For example, when times {(tt1-1) + (tt2-1) + , ..., + (tt(2-i))} are added, in a case where the first Time T3 becomes smaller than Time {(tt1-1) + (tt2-1) + ,..., + (tt(2-i))}, the control unit 20 substitutes Time {T3 - (ttl-1) - (tt2-1) - , ..., - (tt(2-(i-1))} into the model data L corresponding to Time (tt(2-i)) to specify the fault.

Next, in Step S26, the control unit 20 reads out the image data of the CAD data in the memory unit 30 to the data in the RAM unit 21, and marks the position of the fault detected in Step S25 on the image data. The control unit 20 outputs the image data with the fault marked to the display unit 50.

Then, in Step S27, the display unit 50 receives and displays the image data with the fault marked. As a result, in the fault detection apparatus of the third modification, it is possible to detect the fault of the test apparatus with a high accuracy similarly to the first embodiment.

Further, in the fault detection apparatus of the third modification, the arithmetic processing of Step S25 is significantly reduced compared to the test operation of the first embodiment. Therefore, with the test operation of the third modification, the fault detecting time can be shorter than that in the first embodiment.

Further, the fault detection apparatus of the second modification can be applied to the fault detection apparatus of the third modification. In the case, it is possible to shorten the fault detecting time more than that in the third modification.

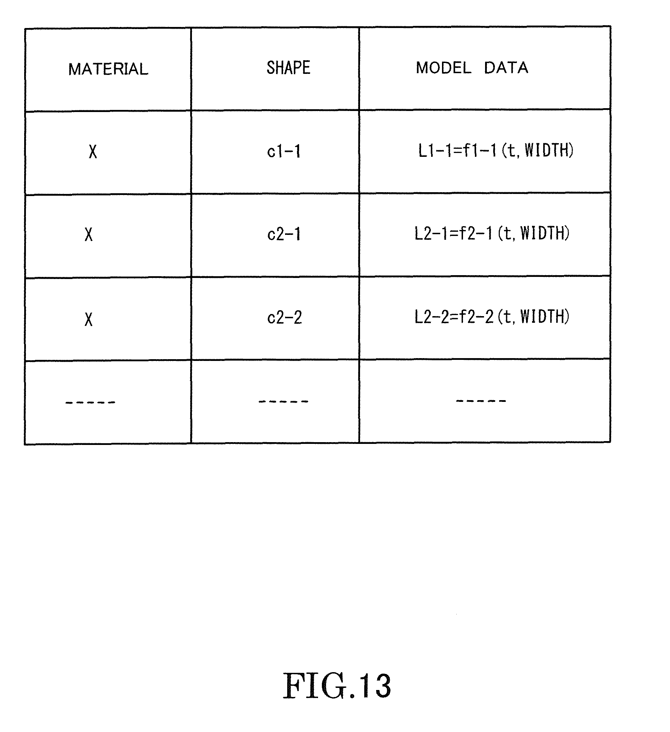

A fault detection apparatus of a second embodiment will be described with reference to Fig. 13. Fig. 13 is a diagram illustrating a table relating to the model data which is stored in the memory unit of the fault detection apparatus.

In the fault detection apparatus of the second embodiment, the model data of the memory unit 30 is differently configured from that of the fault detection apparatus of the first embodiment. The other configurations are the same, and thus only the different portions will be described.

The memory unit 30 of the fault detection apparatus of the embodiment also stores the model data. Herein, the model data is data (for example, function data) which is obtained by modeling a conductivity characteristic of a pulse wave for each component or portion. The model data is used for specifying a fault in a component or a portion based on data output from the time domain reflectometry unit 40 to be described below, the image data, and the characteristics data.

As illustrated in Fig. 13, the model data is expressed with a function of time t and a function of width. The model data is associated with each material and shape. For example, when the characteristics data is a material X and a shape c2-1, the model data L2-1 satisfies Equation (1) expressed in the first embodiment.

Herein, the model data L2-1 represents a predicted conduction distance over which a pulse wave is advanced while a time t elapses after the pulse wave is input from an end of a wiring (or a portion of the wiring) having the material X and the shape c2-1 until the pulse wave is conducted to the other end of the wiring (or a portion of the wiring).

A function f2-1(t) is a function which has a positive correlation time t and has a negative correlation with a width of the wiring.

The model data f1-1(t), f2-1(t), and so on each are stored in the memory unit 30 in association with the characteristics data. In addition, in the embodiment, the memory unit 30 stores the model data in association with the characteristics data. However, the model data may be stored in the memory unit 30 in association with each component or portion.

Herein, variables of the model data of the embodiment have been described using the characteristics data such as time and width, but the invention is not necessarily limited to these variables. In a case where there is characteristics data which can be input as a variable in the model data, the model data may be used for a function of the characteristics data.

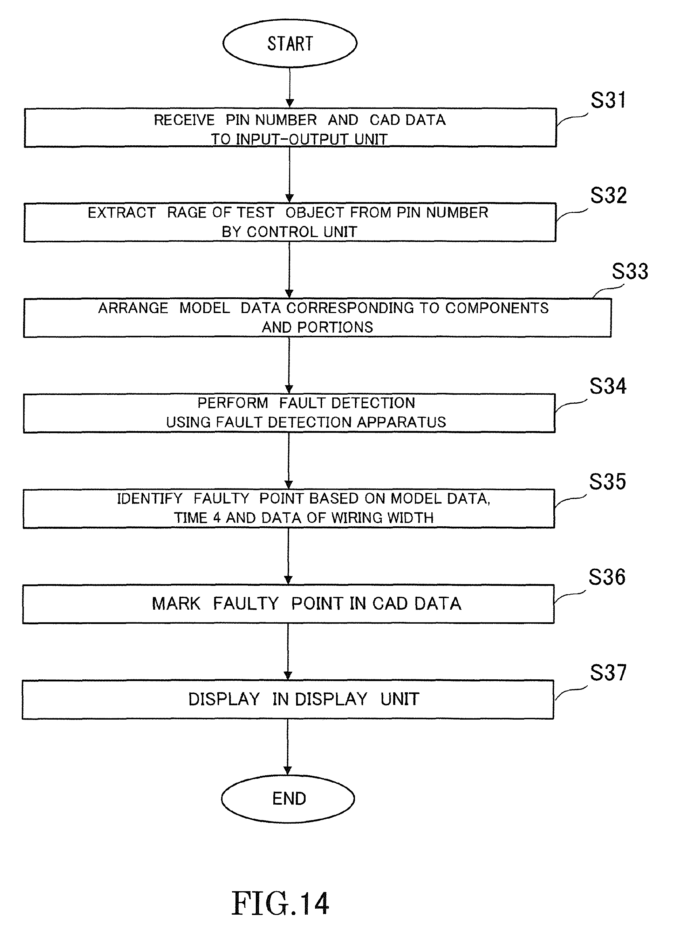

A test operation of the fault detection apparatus will be described with reference to Fig. 14. Fig. 14 is a flowchart illustrating the test operation of the fault detection apparatus. Herein, the characteristics data of the CAD data of each component included in the test apparatus 200 or each of a plurality of portions obtained by dividing the component is stored in the characteristics data unit 34 in advance. The image data of the CAD data is stored in the image data unit 33 in advance. The model data corresponding to all the components and portions used in the test apparatus 200 is stored in the model data unit 32 in advance.

First, when a pin number of a solder ball of the test object is acquired in Step S31, the input-output unit 10 outputs the pin number to the control unit 20. In addition, in Step S31, when information data such as a material of a solder resist, a material of a wiring, a material and a size of a solder ball, and a height of a wiring (a height in a direction perpendicular to a plan on which the wiring is extended) is acquired as well as the pin number, the input-output unit 10 outputs the information data to the control unit 20.

Next, in Step S32, the operation unit 24 of the control unit 20 sets a range electrically connected to the solder ball of the selected pin number as the test object, and extracts the range of the test object from the CAD data.

Subsequently, in Step S33, the operation unit 24 reads out the model data corresponding to the components and the portions included in the range of the test object to the data in the RAM unit 21 such that the pulse wave can be arranged in a conducting order. At the time, the model data is selected after being associated with the characteristics data which is not a variable of the model data, and reads out to the RAM unit 21.

Then, in Step S34, the control unit 20 outputs a signal to start the fault detection test to the time domain reflectometry unit 40. Therefore, the fault detection test is performed. The time domain reflectometry unit 40 brings the probe into contact with the solder ball of the test object of the test apparatus 200. The time domain reflectometry unit 40 measures the reflected-wave measurement time which is a time taken until the reflection signal (the reflected pulse wave) SG2 is received after the high-speed pulse signal SG1 is transmitted to the test apparatus 200 through the probe.

The time domain reflectometry unit 40 outputs the measured Time T4 as information data to the control unit 20.

Next, in Step S35, the control unit 20 specifies a fault based on the model data in the conducting order of the pulse wave obtained in Step S33, Time T4 obtained in Step S34, and the data of the wiring width.

At the time, also the data of the wiring width which is a variable of the model data is read from the characteristics data of the CAD data to the RAM unit 21, and substitutes the width data into the next model data. In a case where the wiring width of each component or portion varies while other characteristics data such as the material and the shape does not vary, it is desirable to calculate the fault using the same model data.

Subsequently, in Step S36, the control unit 20 reads out the image data of the CAD data from the memory unit 30 to the data in the RAM unit 21, and marks the position of the fault detected in Step S35 on the image data. The control unit 20 outputs the image data with the fault marked to the display unit 50.

Then, in Step S37, the display unit 50 receives and displays the image data with the fault marked. As a result, similarly to the first embodiment, the fault detection apparatus of the second embodiment can detect the fault of the test apparatus with a high accuracy.

Further, in the fault detection apparatus of the second embodiment, the control unit 20 specifies the fault based on the model data in the conducting order of the pulse wave obtained in Step S33, Time T4 obtained in Step S34, and the data of the wiring width. As a result, in a case where the wiring width of each component or portion varies while other characteristics data such as the material and the shape does not vary, the control unit 20 calculates the fault using the same model data. Therefore, in the embodiment, the size of the memory unit 30 can be smaller compared to the first embodiment.

While certain embodiments have been described, these embodiments have been presented by way of example only, and are not intend to limit the scope of the inventions. Indeed, the novel embodiments described herein may be embodied in a variety of the other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

**Claims**

1. A fault detection apparatus comprising:

   a measurement unit to measure a first time period taken until a reflection signal reflected on a fault of a test apparatus is received after a first signal is transmitted to the test apparatus;
   a memory unit to include a CAD data unit having CAD data of the test apparatus, and a model data unit to store model data indicating a relation between the first time period and a predicted conduction distance of the first signal according to the CAD data;
   a control unit to calculate a range of a test object selected in the test apparatus based on the CAD data, calculate the predicted conduction distance from the first time period based on the model data, and specify a position of a fault of the test apparatus separated by the predicted conduction distance from the measurement unit in the range of the test object; and
   a display unit to display the position of the fault in the CAD data.

2. The fault detection apparatus according to claim 1, wherein
   the CAD data unit includes an image data unit and a characteristics data unit,
   image data stored in the image data unit is data indicating an image of a portion included in components of the test apparatus when viewed from the upper face, and
   the characteristics data stored in the characteristics data unit includes data of a position, a slope, a shape, and a material of the portion.

3. The fault detection apparatus according to claim 2, wherein
   the memory unit further includes a model data unit, and
   the model data stored in the model data unit is data represented by a function defining a conductivity characteristic of a pulse wave for each of the components or the portions.

4. The fault detection apparatus according to claim 1, wherein
   the control unit is provided with a RAM unit, a library unit, a division unit, and an operation unit.

5. The fault detection apparatus according to claim 4, wherein

the RAM unit stores the CAD data.

6.  The fault detection apparatus according to claim 4, wherein
    the division unit divides image data of the CAD data into components of the test apparatus.

7.  The fault detection apparatus according to claim 4, wherein
    the library unit stores data indicating a determination reference for dividing the component into the portions.

8.  The fault detection apparatus according to claim 4, wherein
    when a fault of the test apparatus is detected, the operation unit applies data output from the measurement unit to the model data to specify a fault of the component or the portion.

9.  The fault detection apparatus according to claim 1, wherein
    the first signal is input to the test apparatus through a probe abutting on an external terminal of the test apparatus.

10. The fault detection apparatus according to claim 9, wherein
    the first signal is a high-speed pulse signal.

11. The fault detection apparatus according to claim 1, wherein
    the fault detection apparatus is applied to detect a short circuit or open circuit of a wiring or connection portion in a process of mounting the test apparatus.

12. The fault detection apparatus according to claim 1, wherein
    the test apparatus is a resin-sealing semiconductor apparatus is stacked with a semiconductor chip and provided with a ball terminal.

13. The fault detection apparatus according to claim 1, wherein
    the test apparatus is an SSD card or an SD card is stacked with a non-volatile semiconductor memory chip.

14. The fault detection apparatus according to claim 1, wherein
    a relation between a distance (L) to a fault of the test apparatus and the first time period (t), that is, a reflected-wave measurement time, is expressed as follows:

$$L = (C_o \times t)/\{2 \times \varepsilon_{ef}^{(1/2)}\} + A$$

(where, Co is a light speed, $\varepsilon_{ef}$ is an effective relative dielectric constant, and A is a constant).

200

TEST
APPARATUS

40

100

SG1  SG2

TIME DOMAIN REFLECTOMETRY UNIT

20  22  33  31  30  34

21

| RAM UNIT | LIBRARY UNIT | | IMAGE DATA UNIT | CHARACTERISTICS DATA UNIT |

CAD DATA UNIT

| DIVISION UNIT | OPERATION UNIT | | MODEL DATA UNIT |

CONTROL UNIT  24  MEMORY UNIT

23  32

50

INPUT-OUTPUT UNIT  DISPLAYT UNIT

10  FAULT DETECTION APPARATUS

FIG.1

FIG.2

EP 2 824 465 A1

FIG.3

EP 2 824 465 A1

207(1-10)

207(1-13)

207(1-12)

207(1-11)

207(1-9)

207(1-8)

207(1-6)

207(1-7)

207(1-5)

207(1-4)

208(1)

207(1)

207(1-3)

207(1-2)

207(1-1)

206(1)

FIG.4

FIG.5

| | WIDTH (FIRST DIAMETER) | LENGTH (SECOND DIAMETER) | BARYCENTER COORDINATE | SLOPE | MATERIAL | SHAPE |
|---|---|---|---|---|---|---|
| SOLDER BALL 206(1) | a1-1 | b1-1 | - - - - - | - - - - | X | c1-1 |
| FIRST WIRING 207(1-1) | a2-1 | b2-1 | - - - - - | - - - - | X | c2-1 |
| FIRST WIRING 207(1-2) | a2-2 | b2-2 | - - - - - | - - - - | X | c2-2 |
| - - - - - | - - - - - | - - - - - | - - - - - | - - - - | - - - - - | - - - - - |
| FIRST WIRING 207(1-12) | a2-12 | b2-12 | - - - - - | - - - - | X | c2-12 |
| FIRST WIRING 207(1-13) | a2-13 | b2-13 | - - - - - | - - - - | X | c2-13 |
| VIA 208(1) | a3-1 | b3-1 | - - - - - | - - - - | X | c3-1 |

# FIG.6

| MATERIAL | WIDTH (FIRST DIAMETER) | SHAPE | MODEL DATA |
|----------|------------------------|-------|------------|
| X | a1-1 | c1-1 | L1-1=f1-1 (t) |
| X | a2-1 | c2-1 | L2-1=f2-1 (t) |
| X | a2-2 | c2-2 | L2-2=f2-2 (t) |
| ----- | ----- | ----- | ----- |

# FIG.7

START

RECEIVE PIN NUMBER TO INPUT-OUTPUT UNIT — S1

EXTRACT RAGE OF TEST OBJECT FROM PIN NUMBER
BY CONTROL UNIT — S2

ARRANGE MODEL DATA CORRESPONDING TO COMPONENTS
AND PORTIONS — S3

PERFORM FAULT DETECTION USING
FAULT DETECTION APPARATUS — S4

IDENTIFY FAULTY POINT — S5

MARK FAULTY POINT IN CAD DATA — S6

DISPLAY IN DISPLAY UNIT — S7

END

# FIG.8

(S4)

ASSIGN TIME T1 TO LEAD MODEL DATA — S5-1

i=1, j=1 — S5-2

CALCULATE $L_{i-j}(T1)$ — S5-3

$L_{i-j}(T1) > b_{i-j}$ ? — S5-4

YES

① INCREMENT $i$ or $j$

② CALCULATE $T(i)(j)$

③ SET $(T1 - \sum T(i)(j))$ INSTEAD OF T1 — S5-5

NO

EXTRACT $L_{i-j}(T1)$ AS FAULTY POINT — S5-6

(S6)

FIG.9

START

RECEIVE PIN NUMBER AND CAD DATA
TO INPUT-OUTPUT UNIT — S11

EXTRACT RAGE OF TEST OBJECT FROM PIN NUMBER
BY CONTROL UNIT — S12

DIVIDE INTO COMPONENTS AND PORTIONS
IN RANGE OF TEST OBJECT — S13

ARRANGE MODEL DATA CORRESPONDING TO COMPONENTS
AND PORTIONS — S14

PERFORM FAULT DETECTION
USING FAULT DETECTION APPARATUS — S15

IDENTIFY FAULTY POINT — S16

MARK FAULTY POINT IN CAD DATA — S17

DISPLAY IN DISPLAY UNIT — S18

END

FIG.10

| MATERIAL | WIDTH (FIRST DIAMETER) | SHAPE | TIME | MODEL DATA |
|----------|------------------------|-------|------|------------|
| X | a1-1 | c1-1 | tt1-1 | L1-1=f1-1 (t) |
| X | a2-1 | c2-1 | tt2-1 | L2-1=f2-1 (t) |
| X | a2-2 | c2-2 | tt2-2 | L2-2=f2-2 (t) |
| ----- | ----- | ----- | ----- | ----- |

# FIG.11

START

RECEIVE PIN NUMBER AND CAD DATA
TO INPUT-OUTPUT UNIT — S21

EXTRACT RAGE OF TEST OBJECT FROM PIN NUMBER
BY CONTROL UNIT — S22

ARRANGE MODEL DATA CORRESPONDING TO COMPONENTS AND PORTIONS,
AND ARRANGE TIME tt CORRESPONDING TO MODEL DATA — S23

PERFORM FAULT DETECTION
USING FAULT DETECTION APPARATUS — S24

COMPARE MAGNITUDE OF SUM OF TIME T3 and TIME tt,
IDENTIFY FAULTY POINT — S25

MARK FAULTY POINT IN CAD DATA — S26

DISPLAY IN DISPLAY UNIT — S27

END

FIG.12

| MATERIAL | SHAPE | MODEL DATA |
|----------|-------|------------|
| X | c1-1 | L1-1=f1-1 (t, WIDTH) |
| X | c2-1 | L2-1=f2-1 (t, WIDTH) |
| X | c2-2 | L2-2=f2-2 (t, WIDTH) |
| ----- | ----- | ----- |

# FIG.13

START

RECEIVE PIN NUMBER AND CAD DATA
TO INPUT-OUTPUT UNIT — S31

EXTRACT RAGE OF TEST OBJECT FROM PIN NUMBER
BY CONTROL UNIT — S32

ARRANGE MODEL DATA CORRESPONDING TO COMPONENTS
AND PORTIONS — S33

PERFORM FAULT DETECTION
USING FAULT DETECTION APPARATUS — S34

IDENTIFY FAULTY POINT BASED ON MODEL DATA,
TIME 4 AND DATA OF WIRING WIDTH — S35

MARK FAULTY POINT IN CAD DATA — S36

DISPLAY IN DISPLAY UNIT — S37

END

FIG.14

FIG.15

<table>
<tr><td colspan="2" align="center">**INTERNATIONAL SEARCH REPORT**</td><td>International application No.<br>PCT/JP2012/005415</td></tr>
</table>

**A. CLASSIFICATION OF SUBJECT MATTER**
*G01R31/02*(2006.01)i, *G01R31/04*(2006.01)i, *G01R31/28*(2006.01)i

According to International Patent Classification (IPC) or to both national classification and IPC

**B. FIELDS SEARCHED**

Minimum documentation searched (classification system followed by classification symbols)
G01R31/02, G01R31/04, G01R31/28

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2004-132805 A  (Zuken Inc.),<br>30 April 2004 (30.04.2004),<br>paragraphs [0084], [0170] to [0185]<br>(Family: none) | 1,9-14<br>2-8 |

☐ Further documents are listed in the continuation of Box C. ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>26 November, 2012 (26.11.12) | Date of mailing of the international search report<br>04 December, 2012 (04.12.12) |
|---|---|
| Name and mailing address of the ISA/<br>Japanese Patent Office | Authorized officer |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012045742 A
- JP 2003124851 A

- JP 9061486 A